# EUROPEAN PATENT SPECIFICATION

(11) **EP 4 278 383 B1**
(45) Date of publication and mention of the grant of the patent: **29.10.2025**
(21) Application number: 22719531.0
(22) Date of filing: 29.03.2022
(51) Int. Cl.: H01L 25/07, H01L 23/00

(54) **POWER MODULE AND METHOD FOR ASSEMBLING A POWER MODULE**
LEISTUNGSMODUL UND VERFAHREN ZUR MONTAGE EINES LEISTUNGSMODULS
MODULE D'ALIMENTATION ET PROCÉDÉ D'ASSEMBLAGE DE MODULE D'ALIMENTATION

(43) Date of publication of application: 22.11.2023
(73) Proprietor: Hitachi Energy Ltd, 8050 Zürich (CH)
(72) Inventor: SCHROEDER, Arne, 3004 Bern (CH); KICIN, Slavo, 8049 Zürich (CH)
(74) Representative: Epping - Hermann - Fischer
(86) International application number: PCT/EP2022/058288
(87) International publication number: WO 2023/186272

(56) References cited:
- EP-A1- 3 340 446
- WO-A1-2020/158057
- US-A1- 2020 286 864

## Description

The present disclosure relates to a power module and a method for assembling a power module.

Power electronic devices, such as converters, may comprise a plurality of power semiconductors. The semiconductors may be housed by so-called power modules. Prior art document WO2020/158057 A1 discloses a power module, comprising a first substrate with a first gate connection point, a second substrate with a second gate connection point, wherein the first gate connection point and the second connections point are electrically connected in parallel to a common terminal, wherein the common terminal is a common gate terminal, a plurality of power semiconductor chips, wherein a first part of the power semiconductor chips is mounted on the first substrate and electrically connected to the first gate connection point, and wherein a second part of the power semiconductor chips is mounted on the second substrate and electrically connected to the second gate connection point,an oscillation damping device, wherein the oscillation damping device is electrically connected between the first substrate and the second substrate, wherein the connection of the first gate connection point and the second gate connection point to the common terminal comprises an asymmetric layout, wherein the connection of the first gate connection point to the common terminal comprises a distance to the connection of the second gate connection point to the common terminal, such that the electrical path of the connections of the first and second substrates with the common terminal is asymmetric, the first gate connection point is spaced further away from a gate terminal line than the second gate connection point.

There is a need for an improved power module, e.g. for a power module that enables fast switching. Furthermore, there is a need for a method for assembling such a power module.

Embodiments of the disclosure relate to an improved power module. Other embodiments of the disclosure relate to a method for assembling a power module.

According to the present invention, there is provided a power module according to claim 1.

The power module, for example, is part of a so-called half-bridge power module. For example, the power semiconductor chips are wide bandgap silicon carbide power semiconductors.

A half bridge is an electrical circuit, comprising two switch elements or two pairs consisting of each one switch element and one diode, connected in series between two DC connection points and providing an AC connection point or output point in between. The DC connection points and the AC connection point / output point may be electrically connected to the power terminals of the power module. Each switch element may be composed of one or more semiconductor switches electrically connected in parallel. The switch elements are, e.g., realized by the above mentioned power semiconductor chips.

The power module may be employed in an electrical converter or inverter, which, for example, may rectify an AC voltage to be supplied to a DC link or a battery. It may also be possible that the inverter generates an AC voltage from a DC voltage to be supplied to an electrical motor, such as the motor of an electric vehicle. The electrical converter may also be a DC-DC converter. The power module may be used in automotive applications, such as electric cars, motorbikes, busses, off-road vehicles.

The power module may be an inverter or converter, e.g. for renewable energies such as wind turbines, solar power panels, tidal power plants and electric vehicles (EVs), or traction applications. The power module may be realized in a so called six-pack configuration with three half-bridge power semiconductor modules for the three phases.

The power module may be adapted for processing currents of more than 5 A, in particular of more than 10 A. power module may be adapted for processing voltages below 1 kV, or may be adapted for processing voltages between 1 kV and 30 kV.

The power module comprises two separate substrates. The substrates are configured to carry and support the power semiconductor chips. Furthermore, the substrates are configured to electrically connect the chips. The first part of the chips is mechanically and electrically connected to the first substrate. The second part of the chips is electrically and mechanically connected to the second substrate. It is also possible to have more than two substrates electrically connected in parallel. Thus, the chips of the power module are distributed on several, at least two, substrates. For example, each substrate comprises 10, 20 or more chips.

In particular, the first substrate and the second substrate are part of a first switch side. The device may comprise further substrates for a second switch side. The chips of the first side are connected in parallel. The gates of the chips are connected to the common terminal via the first connection point and the second connection point. The first connection point is configured for electrical contacting of the first substrate. The second connection point is configured for electrical contacting of the second substrate.

To prevent destructive oscillation between the two substrates, the oscillation damping device is connected between the two substrates. Thus, even when a fast switching is performed, potential destructive oscillations are sufficiently damped. Destructive oscillations, for example, occur during turnoff and they are partially self-excited via the Miller capacitance. Such resonances are triggered when the parasitic gate loop inductances of the two substrates are significantly different. The oscillation damping device allows the elimination of destructive resonances without compromising the switching performance of the power module. The oscillation damping device includes at least one of a dissipating or high impedance element to damp resonances.

According to embodiments, the oscillation damping device comprises a damper. The damper comprises a resistor. The damper is electrically connected to the first substrate and the second substrate in a region outside the first and the second connection points. The damper, in particular, is not in direct contact with the first or the second connection point. The damper is connected to the substrates. In particular, the damper is electrically connected between the first and the second substrate. Thus, there is no need, for example, to place a resistor directly on the connection points. This improves switching speed. Resonances are reliably removed.

According to embodiments the damper comprises a capacitor. The capacitor and the resistor are electrically connected to each other. Thus, it is possible to just have a resistor as a damper. In addition, it is possible to have the resistor and a series capacitor as the damper. The capacitor prevents a low frequency current flow between substrate and hence protects from breaking the resistor. For example, the capacitor and the resistor are connected to each other by wire bonds.

According to embodiments, the resistor is connected to the first and/or the second substrate by wire bonds.

Alternatively or in addition, the resistor and/or the capacitor are connected by a sintered connection to the first and/or the second substrate. Alternatively or in addition, the resistor and/or the capacitor are connected to the first and/or the second substrate by a soldered connection. The connection, for example, is an electrical connection and/or a mechanical connection.

According to embodiments, the damper comprises a plurality of resistors. The resistors are connected in parallel. Each resistor of the resistors is connected to the first and the second substrate, for example by a wire bond connection. According to embodiments, the damper comprises a plurality of capacitors.

According to an embodiment not forming part of the present invention but useful for understanding it, the oscillation damping device comprises a first ferrite bead. The oscillation damping device comprises a second ferrite bead. The first ferrite bead is electrically connected between the first connection point and the common terminal. The second ferrite bead is electrically connected between the second connection point and the common terminal.

The ferrite beads each comprise an impedance which is highly frequency dependent. The resistance of the ferrite bead is negligible at frequencies below about 1 MHz. A substantial resistance occurs at higher frequencies. Thus, the switching of the semiconductor chips of the power module is not affected when ferrite beads are implemented because the switching, for example, normally occurs with frequencies below 1 MHz. Parasitic oscillations or destructive oscillations occur usually between 10 MHz and 100 MHz. Thus, these oscillations are damped efficiently by the ferrite bead of the damping device.

According to a further embodiment not forming part of the present invention but useful for understanding it, the oscillation damping device comprises a differential mode choke. The differential mode choke is electrically connected between the first connection point and the second connection point and the second connection point and the common terminal. Thus, the differential mode choke is implemented in the gate signal path. The differential mode choke provides a low impedance between the first connection point and the common terminal. Further, the differential mode choke provides a low impedance between the second connection point and the common terminal. Further, the differential mode choke provides a high impedance between the first connection point and the second connection point. This high impedance between the first and second connection point damps resonances and destructive oscillations.

According to embodiments not forming part of the present invention but useful for understanding it, the damping device comprises at least one of the damper, the differential mode choke and the ferrite beads. Thus, any combination of the different embodiments is possible.

According to an embodiment, the power semiconductor chips each are one of: an IGBT, a diode, a MOSFET, a thyristor, a JFET, a HEMT. The substrates, for example, each comprises a top metallization and a bottom metallization and an isolation layer therebetween. The substrate can also be an isolated metal substrate. The substrate may be a direct bonded copper substrate or a direct bonded aluminum substrate or an active metal bracing substrate with an isolating ceramic layer or with an isolating resin layer.

According to the present invention, the power module comprises an asymmetric layout. The connection of the first connection point and the connection of the second connection point to the common terminal comprises line sections of different length. This asymmetric design with different lengths of line sections is possible because the oscillation damping device damps critical oscillations which would otherwise occur with this design.

According to embodiments, during use, the first substrate and the second substrate are at a common electrical potential. As the two substrates are part of the same side of the switch and are connected in parallel, they comprise the same or basically the same electrical potential. Thus, the oscillation damping device is electrically connected to two substrates which comprise a common electrical potential. In particular, the elements of the oscillation damping device, such as for example the resistor, the capacitor, or other elements, are connected between the two substrates and connected to the same potential on the different two substrates.

Further embodiments of the present invention relate to a method for assembling a power module. The method may be used for assembling the power module according to an embodiment described herein. Therefore, all features disclosed in connection with the power module are also disclosed for the method and vice versa.

According to the invention, there is provided a method according to claim 9.

Herein after, the power module and the method for assembling a power module will be explained in more detail with reference to the drawings on the basis of exemplary embodiments. The accompanying figures are included to provide a further understanding. In the figures, elements of the same structure and/or functionality may be referred to by the same reference signs. It is to be understood that the embodiments shown in the figures are illustrative representations and are not necessarily drawn to scale. Insofar as elements or components correspond to one another in terms of their function in different figures, the description thereof is not repeated for each of the following figures. For the sake of clarity, elements may not appear with corresponding reference signs in all figures.

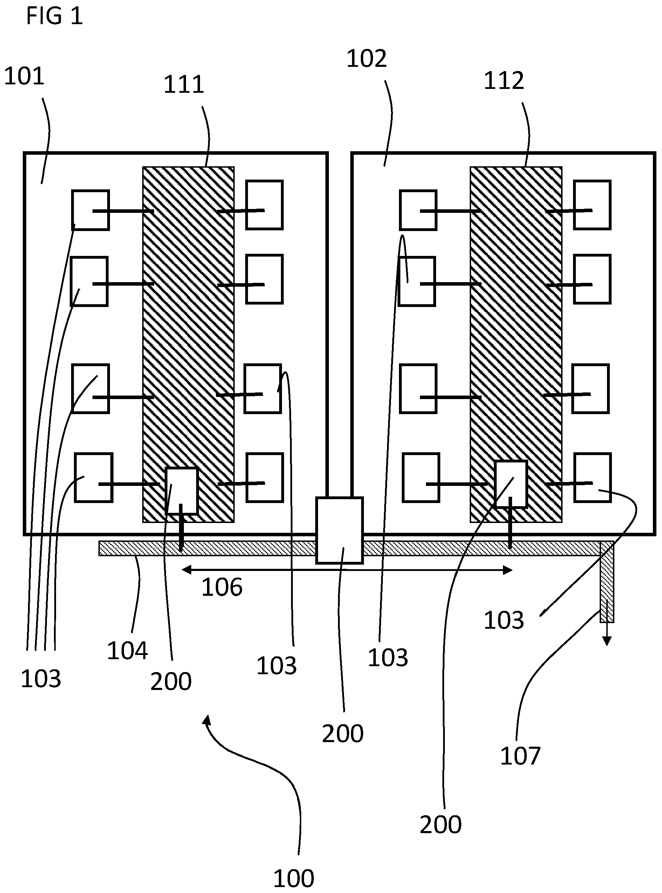

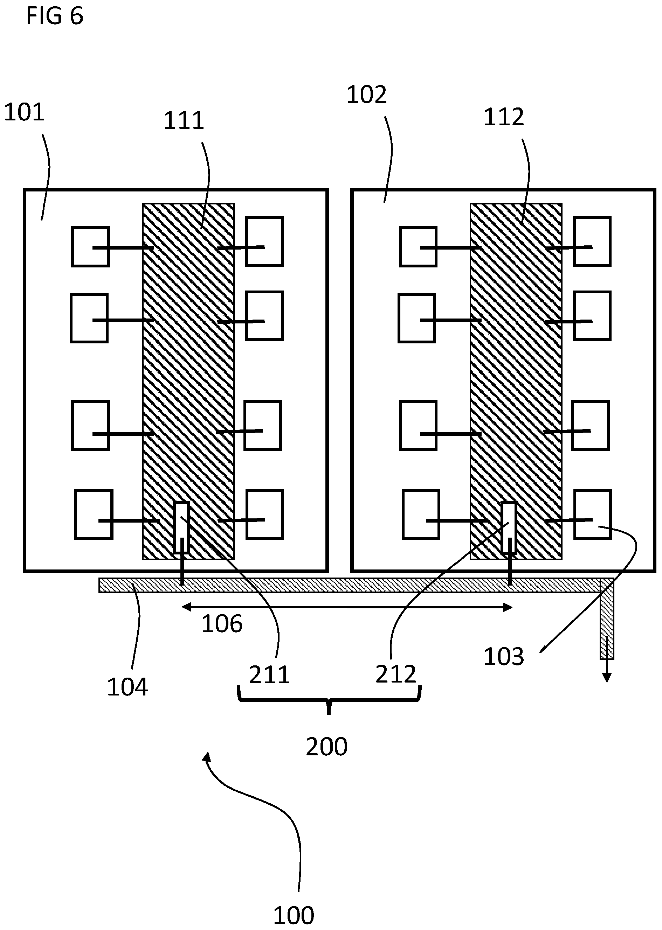

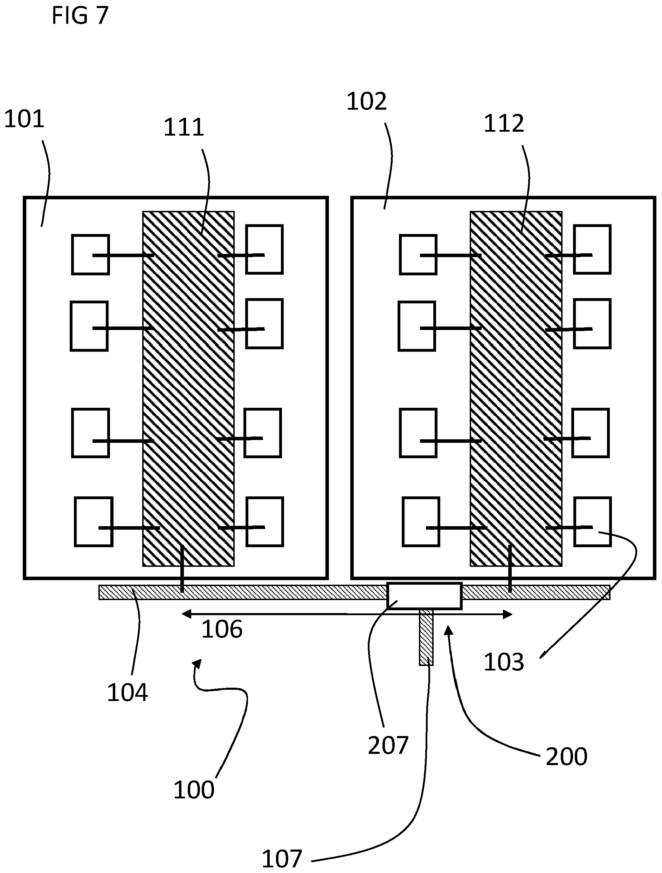

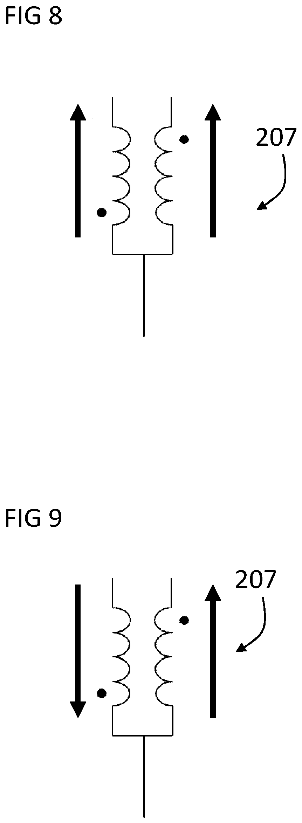

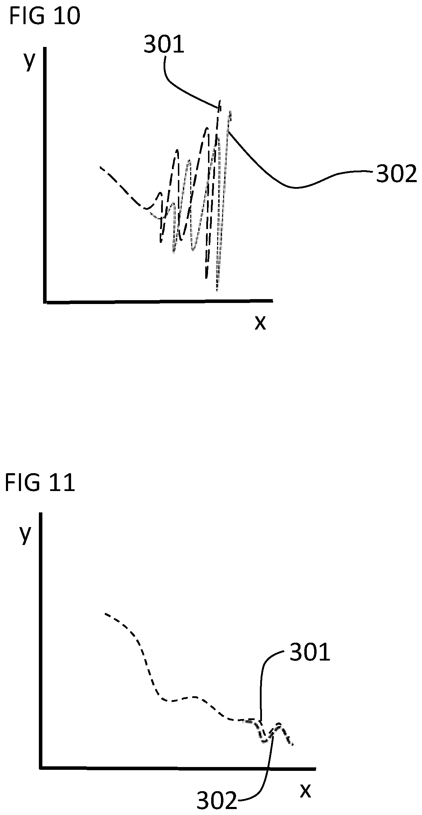

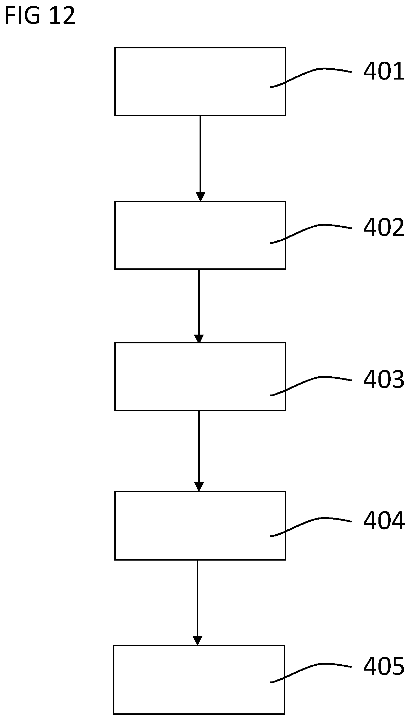

Figures 1 to 5 show embodiments of a power module according to the present invention, Figures 6 and 7 show exemplary embodiments of a power module, not forming part of the present invention but useful for understanding it, Figures 8 and 9 show exemplary embodiments of a differential mode choke, not forming part of the present invention but useful for understanding it, Figure 10 shows an exemplary embodiment of voltage curves, not forming part of the present invention but useful for understanding it. Figure 11 shows an embodiment of voltage curves in accordance with the present invention, and Figure 12 shows a flowchart of an embodiment of a method for assembling a power module, according to the present invention.

Figure 1 shows an embodiment of a power module 100, according to the present invention.

The power module may be employed in an electrical converter or inverter. For example, the power module is part of a module which is used to rectify an AC voltage to be supplied to a DC link or a battery. It is also possible that the inverter generates an AC voltage from a DC voltage.

The power module 100 comprises a first substrate 101. The power module 100 comprises a second substrate 102. The first substrate 101 and the second substrate 102 are separate substrates. The power module 100 comprises a so-called multi-substrate layout. The two substrates 101, 102 are two standalone substrates that can be handled independently from each other. The two substrates 101, 102 are mechanically and electrically connected together during manufacturing of the power module 100 and before that can be stored and handled independently.

Each of the substrates 101, 102 comprises a plurality of power semiconductor chips 103. In particular, the chips 103 are each SiC chips. The use of other chip types is also possible. For example, each substrate 101, 102 comprises 10 chips or more, for example 20 chips 103.

The chips 103 of the first substrate 101 are each connected to a first connection point 111, which may be also called gate trace or gate runner. In particular, all gates of the chips 103 of the first substrate 101 are electrically connected to the first connection point 111. The first connection point 111 may also be called gate connection point.

The chips 103 of the second substrate 102 are connected to a second connection point 112, which may be also called gate trace or gate runner. In particular, the gates of the chips 103 of the second substrate 102 are connected to the second connection point 112. The second connection point 112 may also be called gate connection point.

The first substrate 101 comprises the first connection point 111 to be electrically connected to the gates of the chips 103 corresponding to the first substrate 101. The second substrate 102 comprises the second connection point 112 to be electrically connected to the gates of the chips 103 of the second substrate 102.

The first substrate 101 and the second substrate 102 are both electrically connected to a common terminal 104, which may be also called common trace. The common terminal is connected in particular to a gate terminal of the power module 100. Thus, the first connection point 111 and the second connection point 112 are both connected to a gate terminal via the common terminal 104. Therefore, the chips 103 of the first substrate 101 and the second substrate 102 are connected in parallel.

Figure 1 schematically shows the asymmetric design of the power module 100 regarding the electrical connection of the substrates 101, 102 to the common terminal 104 and, in particular, to a gate terminal line 107 which connects the common terminal 104 to the gate terminal. The first substrate 101 is connected to the common terminal 104 at a different location than the second substrate 102. The connection of the first connection point 111 to the common terminal 104 comprises a distance 106 to the connection of the second connection point 112 to the common terminal 104. The first connection point 111 is spaced further away from the gate terminal line 107 than the second connection point 112. The connection point 111 is located further away from the gate terminal line 107 by the distance 106. The electrical path of the connections of the two substrates 101, 102 with the common terminal 104 is asymmetric. The distance from the first connection point 111 is longer than the distance from the second connection point 112. This distance difference leads to a gate loop inductance difference caused by the distance 106. The gate loop inductance difference is, for example, in the order of 15 nH.

During use of the power module 100, fast switching of the power semiconductor chips 103 may lead to destructive oscillation between the first substrate 101 and the second substrate 102, in particular due to the distance 106. An oscillation loop may extend between the substrates 101, 102 via the gate path, the Miller capacitances, and the drain side of the switches. For example, destructive oscillations occur during turn-off and they are partially self-excited via the Miller capacitance. Such resonances may be triggered when the parasitic gate loop inductances of the two substrates 101, 102 are significantly different as is the case in the schematically shown power module 100.

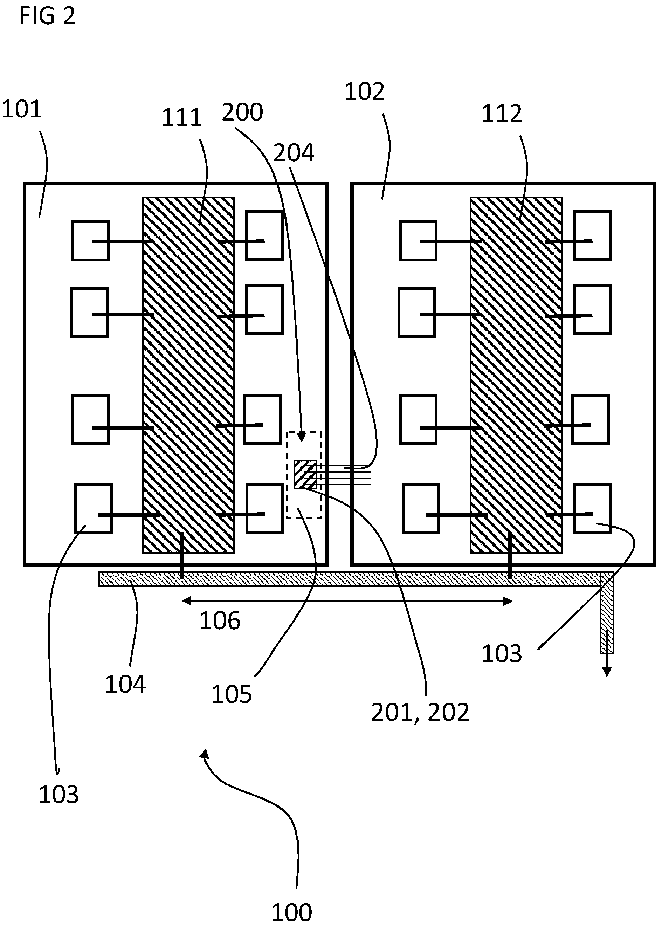

According to the present invention, a dissipating or high impedance element is introduced on or between the substrates 101, 102 to remove, avoid or damp resonances. Thus, a rugged solution for eliminating destructive resonances without compromising the switching performance of the power module 100 and the power semiconductor chips 103 is realized. The dissipating or high impedance elements are realized as a damping device 200. The damping device 200 is schematically shown in Figure 1 and explained in more detail with respect to Figures 2 to 12.

Figure 2 shows a first embodiment of the damping device 200. The damping device 200 comprises a damper 201. The damper 201 is electrically and mechanically connected to the first substrate 101. A wire bond connection 204 electrically connects the damper 201 to the second substrate 102. The damper 201 is arranged in a region 105 of the first substrate 101 that is outside of the first connection point 111. The damper 201, in particular a resistor 202 of the damper 201, is not mechanically connected on a surface of the first connection point 111. There is no direct mechanical nor electrical contact between the damper 201 and the first connection point 111. The region 105 is a region of the first substrate 101 which is completely arranged beside the first connection point 111 without overlap. The wire bond connection 204 is not mechanically directly connected to the second connection point 112 but to the second substrate 10 beside the second connection point 112.

The damper 201 is implemented between the substrates 101, 102. The resistor 202 is inserted in the resonance circuit as a resistive element. The connection between the first connection point 111 and the second connection point 112 to the common terminal 104 could be a direct connection without an additional resistor. Thus, switching speed is increased due to the direct connection of the connection points 111, 112 to the common terminal 104. Resonances are removed by the damper 201.

Both substrates 101, 102 are on the same potential or at least basically on the same potential, for example the drain potential of the switches. Thus, the damper 201 can be realized just with the resistor 202 as shown in Figure 2.

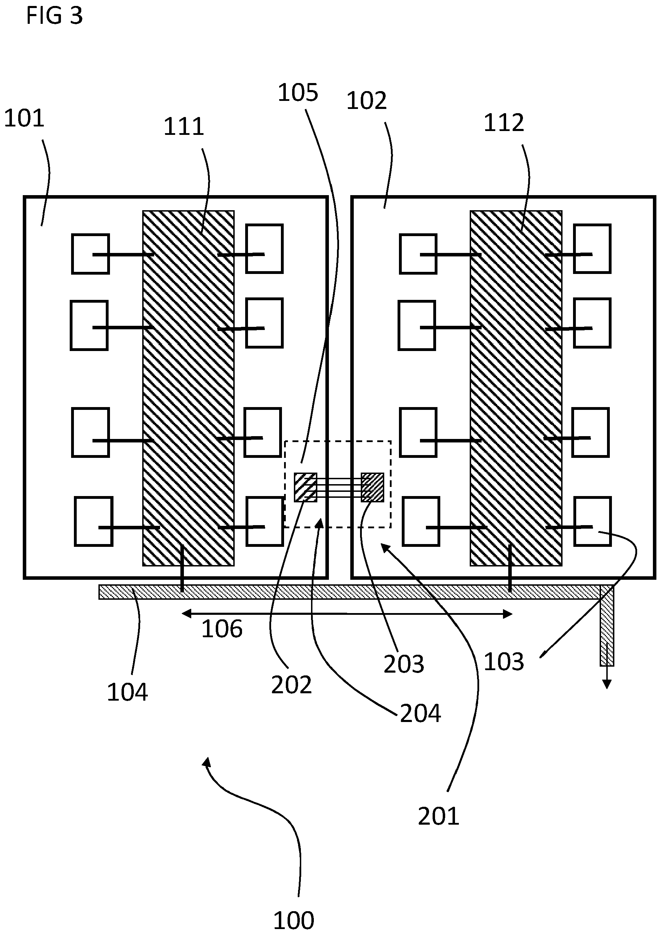

Figure 3 shows a further embodiment of the power module 100 which, in addition to the embodiment shown in Figure 2, comprises a capacitor 203. The capacitor 203 is part of the damper 201. The capacitor 203 and the resistor 202 of the damper 201 are electrically connected in series. Thus, low frequency, which could break the resistor 202, can be avoided by the capacitor 203. For example, the capacitor 203 is connected on the second substrate 101 in the region 105 outside the connection point 112. It is also possible to arrange the resistor 202 and the capacitor 203 in reverse. In the reversed arrangement, the capacitor 203 is arranged on the first substrate 101 and the resistor 202 is arranged on the second substrate 102. The resistor 202 and the capacitor 203 are connected by the wire bond connection 204.

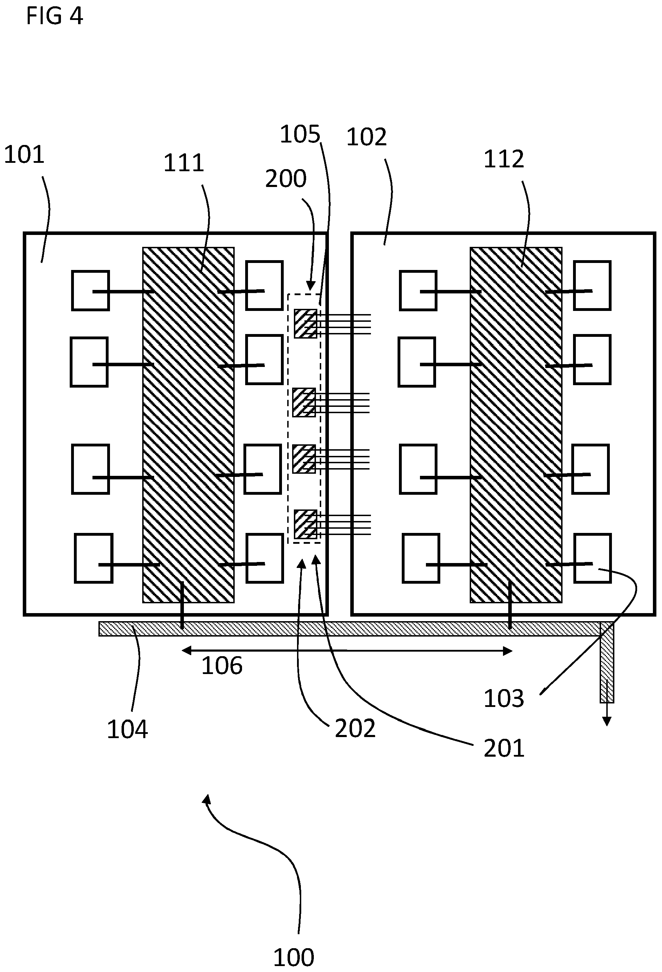

As shown in Figure 4, according to embodiments the damper 201 comprises a plurality of resistors 202. All resistors 202 of the damper 201 are arranged in the region 105 outside the connection points 111, 112. Similarly, the damper 201 according to further embodiments comprises a plurality of capacitors 203, such that a plurality of arrangements as shown in Figure 3 is arranged between the substrates 111, 112.

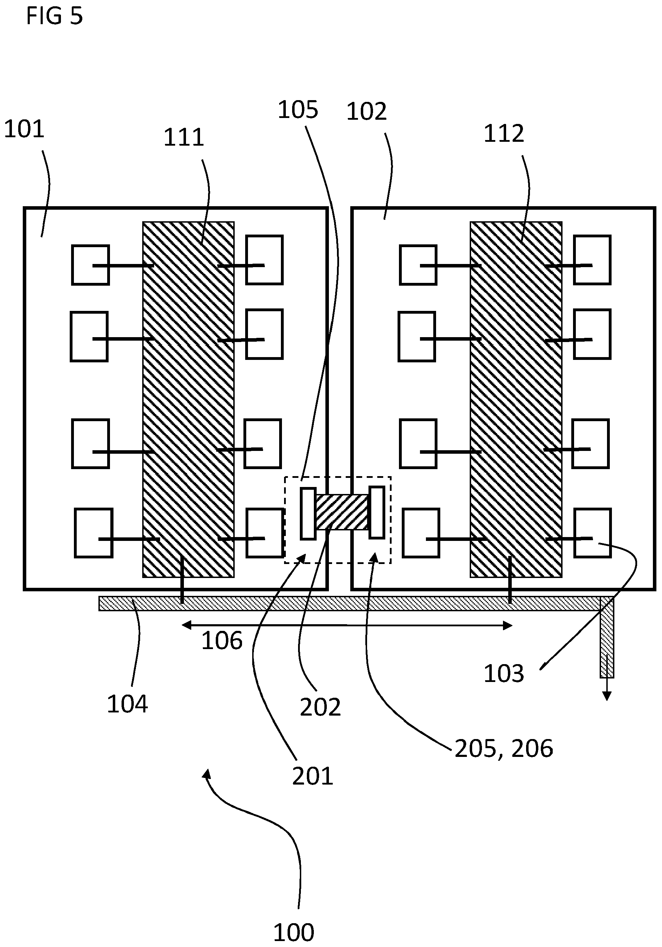

The damper 201 comprises the resistor 202 and the optional capacitor 203. The damper 201 can be realized in many variants, such as the examples shown in Figures 2 to 5. For example, instead of the wire bond connection 204, the damper 201, in particular the resistor 202, is connected to the substrates 101, 102 by a sintered connection 205 and/or a soldered connection 206 (Figure 5). According to the embodiment of Figure 5, the damper 201 connects both substrates 101, 102.

The damper 201, for example, comprises a so-called snubber. For example, the RC snubber is a monolithic RC snubber. The damper comprises some parasitic equivalent series inductance. The damper may comprise a discrete monolithic RC snubber. The RC snubber may also be built on the basis of MLCCs. The properties of the RC snubber are, for example, a resistance of 1 Ω to 1 kΩ and a capacitance of 100 pF to 1 µF.

Figure 6 shows the power module 100 according to an embodiment, not forming part of the present invention but useful for understanding it. The power module 100 comprises a first ferrite bead 211 and a second ferrite bead 212. The ferrite beads 211, 212 are each configured to suppress high frequency electronic noise. The ferrite beads 211, 212 each comprise a ferrite ceramic. The first ferrite bead 211 is connected in series between the first connection point 111 and the common terminal 104. The second ferrite bead 212 is connected in series between the second connection point 112 and the common terminal 104. Thus, the ferrite beads 111, 112 eliminate oscillations between the two substrates 101, 102 during use. For example, the first ferrite bead 211 is arranged on the first connection point 111. For example, the second ferrite bead 212 is arranged on the second connection point 112.

The impedance of the ferrites beads 211, 212 is strongly frequency-dependent. For example, resistance is negligible at frequencies below 1 MHz. A substantial resistance, for example, occurs at higher frequencies. For example, the values for the impedance at the resonance frequency of the ferrite beads is 1 Ω to 1 kΩ. The resonance frequency, for example, is between 100 KHz and 100 MHz.

In particular, according to embodiments the ferrite beads are arranged in the gate signal path. In particular, the ferrite beads are not arranged outside the gate signal path. In particular, the power module 100 comprises as many ferrite beads 211, 212 as substrates 101, 102. The power module 100 in particular comprises more ferrite beads 211, 212 than substrates 101, 102. In particular, the power module 100 does not comprise more substrates 101, 102 than ferrite beads 211, 212. Thus, in particular there is at least one ferrite bead 211, 212 per substrate 101, 102. The ferrite bead 211 is connected with the first connection point 111. Thus, there is no need for individual ferrite beads for each individual chip 103. The same applies to the second substrate 102.

Thus, each substrate 101, 102 is connected to the common terminal 104 via one ferrite bead 211, 212. Reliable switching is possible due to the low resistance of the ferrite beads 211, 212 at typical switching frequency. At the higher oscillation frequencies an oscillation is reliably damped due to the high resistance of the ferrite beads 211, 212 at the oscillation frequencies.

Figure 7 shows the power module 100 according to a further embodiment, not forming part of the present invention but useful for understanding it. The damper 200 comprises a differential mode choke 207. The differential mode choke 207 is implemented in the gate signal path between the common terminal 104 and the gate terminal line 107. In particular the differential mode choke is arranged in the common terminal 104 between the connection to the first substrate 101 and the second substrate 102. The differential mode choke 207 comprises a low impedance between the first connection point 111 and the gate terminal line 107 as well as between the second connection point 112 and the gate line 107.

The differential mode choke 207 provides a high impedance between the first connection point 111 and the second connection point 112. This is also schematically illustrated in Figures 8 and 9, embodiments that do not form part of the present invention but are useful for understanding it. Figure 8 shows the differential mode choke in the so-called common mode to drive the gates of the chips 103. In this mode, the differential mode choke 207 comprises the low impedance. Figure 9 shows the so-called differential mode where spurious oscillations occur. In this mode, the differential mode choke 207 comprises a high impedance. For example, the common mode impedance at resonant frequency is between 1 Ω and 100 kΩ or higher. Typical resonance frequencies are 1 MHz to 1 KHz.

According to embodiments, the differential mode choke is, for example, implemented by using a common mode choke with appropriate connections. The differential mode choke 207 is connected to the common terminal 104 and the connection points 111, 112 as well as the gate terminal line 107 in the manner of a T-junction. The differential mode choke 207 is implemented between the first substrate 101 and the second substrate 102.

Figure 10 schematically shows an example, not forming part of the present invention but useful for understanding it, of a gate voltage 301 of the first substrate 101 and a further gate voltage 302 of the second substrate 102 during turnoff. Figure 10 shows the curves of the gate voltages 301, 302 without a damping device 200.

Figure 11 shows the curves of the gate voltages 301, 302 according to an embodiment of the present invention, with the damping device 200 arranged between the substrates 101, 102. Without the damping device 200, destructive oscillations occur.

Oscillation between the two substrates 101, 102 is shown in Figure 10. These oscillations may lead to damage or even destruction of the power module 100.

As shown in Figure 11, the oscillation does not occur with the damping device 200 according to the different embodiments. Only a slight, uncritical, remainder of the oscillation between the substrates may occur, which does not damage or destroy the power module 100.

In Figures 10 and 11 time is plotted on the X-axis and gate voltage is plotted on the Y-axis.

Thus, with the damping device 200, destructive oscillations are effectively eliminated. Switching performance is significantly increased, in particular because there are no additional resistive elements on the connection points 111, 112, slowing down the switching. It is possible to distribute the power semiconductor chips 103 on multiple substrates 101, 102 and allow an asymmetric design. A well-balanced current sharing between the parallel substrates 101, 102 and between parallel chips 103 is possible. Only a single connection point 111, 112 per substrate 101, 102 is required. This allows cost-effective manufacturing and a low complexity of the power module 100. The asymmetric design of the connection points 111, 112 and the common terminal 104 as well as the gate terminal line 107 allows a reduced complexity of the overall terminal design and connection point design. The power module 100 is realized in a cost-effective manner.

Figure 12 shows a flowchart of an embodiment of a method for assembling a power module 100 according to the present invention. For example, the power module according to one of Figures 2 to 7 can be manufactured with this method.

In a step 401 the first substrate 101 and the second substrate 102 are provided.

In a second step 402 the first connection point 111 of the first substrate 101 and the second connection point 112 of the second substrate 102 are connected in parallel to the common terminal 104.

In a step 403, a first part of the plurality of power semiconductor chips 103 is mounted on the first substrate 102. Step 403 also comprises electrically connecting the chips 103 of the first part to the first connection point 111.

In a step 404, a second part of the plurality of semiconductor chips 103 is mounted on the second substrate 102. Step 404 also comprises electrically connecting the chips 103 of the second part to the second connection point 112.

In a step 405, the oscillation damping device 200 is provided. Step 405 also comprises electrically connecting the oscillation damping device 200 between the first substrate 101 and the second substrate 102.

The sequence of the steps 401 to 405 can also be different than described. For example, step 403 is before the step 402.

The embodiments shown in the Figures 1 to 12 as stated represent exemplary embodiments of the improved power module and method for assembling a power module; therefore, they do not constitute a complete list of all embodiments according to the improved device and method. Actual devices and methods may vary from the embodiments shown in terms of arrangements, devices and elements, for example.

### Reference Signs

- 100: power module
- 101: first substrate
- 102: second substrate
- 103: power semiconductor chip
- 104: common terminal
- 105: region
- 106: distance
- 107: gate terminal line

- 111: first connection point
- 112: second connection point

- 200: damping device
- 201: damper
- 202: resistor
- 203: capacitor
- 204: wire bond connection
- 205: sintered connection
- 206: soldered connection
- 207: differential mode choke

- 211: first ferrite bead
- 212: second ferrite bead

- 301, 302: gate voltage

- 401 - 405: method steps

## Claims

1. Power module (100), comprising
- a first substrate (101) with a first gate connection point (111),
- a second substrate (102) with a second gate connection point (112), wherein the first gate connection point (111) and the second connections point (112) are electrically connected in parallel to a common terminal (104), wherein the common terminal (104) is a common gate terminal,
- a plurality of power semiconductor chips (103), wherein a first part of the power semiconductor chips (103) is mounted on the first substrate (101) and electrically connected to the first gate connection point (111), and wherein a second part of the power semiconductor chips (103) is mounted on the second substrate (102) and electrically connected to the second gate connection point (112),
- an oscillation damping device (200), wherein the oscillation damping device (200) is electrically connected between the first substrate (101) and the second substrate (102), wherein the connection of the first gate connection point (111) and the second gate connection point (112) to the common terminal (104) comprises an asymmetric layout, wherein
- the connection of the first gate connection point (111) to the common terminal (104) is located at a distance (106) to the connection of the second gate connection point (112) to the common terminal (104), such that the electrical path of the connections of the first and second substrates (101, 102) with the common terminal (104) is asymmetric,
- the first gate connection point (111) is spaced further away from a gate terminal line (107) than the second gate connection point (112) by the distance (106).

2. Power module (100) according to claim 1, wherein the oscillation damping device (200) comprises a damper (201), wherein the damper (201) comprises a resistor (202), and wherein the damper (201) is electrically connected to the first substrate (101) and the second substrate (102) in a region (105) outside the first and second gate connection points (111, 112).

3. Power module (100) according to claim 2, wherein the damper (201) comprises a capacitor (203) electrically connected to the resistor (202).

4. Power module (100) according to claim 2 or 3, comprising at least one of a wire bond connection (204), a sintered connection (205) and a soldered connection (206) for electrically connecting the damper (201) to the first substrate (101) or the second substrate (102).

5. Power module (100) according to any one of claims 2 to 3, wherein the damper (201) comprises a plurality of resistors (202), wherein the resistors (202) are connected in parallel.

6. Power module (100) according to any one of the preceding claims, wherein
- the power semiconductor chips (103) are one of: an IGBT, a MOSFET, a diode, a thyristor, a JFET, a HEMT.

7. Power module (100) according to any one of the preceding claims, wherein the first substrate (101) and the second substrate (102) are at a common electrical potential.

8. Power module (100) according to any one of the preceding claims, wherein the second connection point (112) is located between the first connection point (111) and the gate terminal line (107).

9. Method for assembling a power module (100), comprising:
- providing a first substrate (101) with a first gate connection point (111) and a second substrate (102) with a second gate connection point (112),
- connecting the first gate connection point (111) and the second gate connection point (112) in parallel to a common terminal (104), wherein the common terminal (104) is a common gate terminal, such that the connection of the first gate connection point (111) and the second gate connection point (112) to the common terminal (104) comprises an asymmetric layout, such that the connection of the first gate connection point (111) to the common terminal (104) is located at a distance (106) to the connection of the second gate connection point (112) to the common terminal (104), such that the electrical path of the connections of the first and second substrates (101, 102) with the common terminal (104) is asymmetric, the first gate connection point (111) is spaced further away from a gate terminal line (107) than the second gate connection point (112) by the distance (106),
- mounting a first part of a plurality of power semiconductor chips (103) on the first substrate (101) and electrically connecting the first part to the first gate connection point (111),
- mounting a second part of a plurality of power semiconductor chips (103) on the second substrate (102) and electrically connecting the second part to the second gate connection point (112),
- connecting an oscillation damping device (200) electrically between the first substrate (101) and the second substrate (102).

## Patentansprüche

1. Leistungsmodul (100), das Folgendes umfasst:
- ein erstes Substrat (101) mit einem ersten Gate-Verbindungspunkt (111),
- ein zweites Substrat (102) mit einem zweiten Gate-Verbindungspunkt (112), wobei der erste Gate-Verbindungspunkt (111) und der zweite Verbindungspunkt (112) elektrisch parallel mit einem gemeinsamen Anschluss (104) verbunden sind, wobei der gemeinsame Anschluss (104) ein gemeinsamer Gate-Anschluss ist,
- eine Vielzahl von Leistungshalbleiterchips (103), wobei ein erster Teil der Leistungshalbleiterchips (103) auf dem ersten Substrat (101) montiert ist und elektrisch mit dem ersten Gate-Verbindungspunkt (111) verbunden ist, und wobei ein zweiter Teil der Leistungshalbleiterchips (103) auf dem zweiten Substrat (102) montiert ist und elektrisch mit dem zweiten Gate-Verbindungspunkt (112) verbunden ist,
- eine Schwingungsdämpfungsvorrichtung (200), wobei die Schwingungsdämpfungsvorrichtung (200) elektrisch zwischen dem ersten Substrat (101) und dem zweiten Substrat (102) verbunden ist, wobei die Verbindung des ersten Gate-Verbindungspunkts (111) und des zweiten Gate-Verbindungspunkts (112) mit dem gemeinsamen Anschluss (104) ein asymmetrisches Layout umfasst, wobei
- die Verbindung des ersten Gate-Verbindungspunkts (111) mit dem gemeinsamen Anschluss (104) in einem Abstand (106) zu der Verbindung des zweiten Gate-Verbindungspunkts (112) mit dem gemeinsamen Anschluss (104) angeordnet ist, so dass der elektrische Pfad der Verbindungen des ersten und des zweiten Substrats (101, 102) mit dem gemeinsamen Anschluss (104) asymmetrisch ist,
- der erste Gate-Verbindungspunkt (111) um den Abstand (106) weiter von einer Gate-Anschlussleitung (107) entfernt ist als der zweite Gate-Verbindungspunkt (112).

2. Leistungsmodul (100) nach Anspruch 1, wobei die Schwingungsdämpfungsvorrichtung (200) einen Dämpfer (201) umfasst, wobei der Dämpfer (201) einen Widerstand (202) umfasst und wobei der Dämpfer (201) elektrisch mit dem ersten Substrat (101) und dem zweiten Substrat (102) in einem Gebiet (105) außerhalb des ersten und zweiten Gate-Verbindungspunkts (111, 112) verbunden ist.

3. Leistungsmodul (100) nach Anspruch 2, wobei der Dämpfer (201) einen Kondensator (203) umfasst, der elektrisch mit dem Widerstand (202) verbunden ist.

4. Leistungsmodul (100) nach Anspruch 2 oder 3, das eine Drahtbondverbindung (204) und/oder eine Sinterverbindung (205) und/oder eine Lötverbindung (206) zum elektrischen Verbinden des Dämpfers (201) mit dem ersten Substrat (101) oder dem zweiten Substrat (102) umfasst.

5. Leistungsmodul (100) nach einem der Ansprüche 2 bis 3, wobei der Dämpfer (201) mehrere Widerstände (202) umfasst, wobei die Widerstände (202) parallel geschaltet sind.

6. Leistungsmodul (100) nach einem der vorhergehenden Ansprüche, wobei
- die Leistungshalbleiterchips (103) einer von folgenden sind: ein IGBT, ein MOSFET, eine Diode, ein Thyristor, ein JFET, ein HEMT.

7. Leistungsmodul (100) nach einem der vorhergehenden Ansprüche, wobei das erste Substrat (101) und das zweite Substrat (102) auf einem gemeinsamen elektrischen Potential liegen.

8. Leistungsmodul (100) nach einem der vorhergehenden Ansprüche, wobei sich der zweite Verbindungspunkt (112) zwischen dem ersten Verbindungspunkt (111) und der Gate-Anschlussleitung (107) befindet.

9. Verfahren zum Zusammenbau eines Leistungsmoduls (100), das Folgendes umfasst:
- Bereitstellen eines ersten Substrats (101) mit einem ersten Gate-Verbindungspunkt (111) und eines zweiten Substrats (102) mit einem zweiten Gate-Verbindungspunkt (112),
- Verbinden des ersten Gate-Verbindungspunkts (111) und des zweiten Gate-Verbindungspunkts (112) parallel zu einem gemeinsamen Anschluss (104), wobei der gemeinsame Anschluss (104) ein gemeinsamer Gate-Anschluss ist, so dass die Verbindung des ersten Gate-Verbindungspunkts (111) und des zweiten Gate-Verbindungspunkts (112) mit dem gemeinsamen Anschluss (104) ein asymmetrisches Layout umfasst, so dass die Verbindung des ersten Gate-Verbindungspunkts (111) mit dem gemeinsamen Anschluss (104) in einem Abstand (106) zu der Verbindung des zweiten Gate-Verbindungspunkts (112) mit dem gemeinsamen Anschluss (104) angeordnet ist, so dass der elektrische Pfad der Verbindungen des ersten und zweiten Substrats (101, 102) mit dem gemeinsamen Anschluss (104) asymmetrisch ist, der erste Gate-Verbindungspunkt (111) um den Abstand (106) weiter von einer Gate-Anschlussleitung (107) beabstandet ist als der zweite Gate-Verbindungspunkt (112),
- Montieren eines ersten Teils einer Vielzahl von Leistungshalbleiterchips (103) auf dem ersten Substrat (101) und elektrisches Verbinden des ersten Teils mit dem ersten Gate-Verbindungspunkt (111),
- Montieren eines zweiten Teils einer Vielzahl von Leistungshalbleiterchips (103) auf dem zweiten Substrat (102) und elektrisches Verbinden des zweiten Teils mit dem zweiten Gate-Verbindungspunkt (112),
- elektrisches Verbinden einer Schwingungsdämpfungsvorrichtung (200) zwischen dem ersten Substrat (101) und dem zweiten Substrat (102).

## Revendications

1. Module d'alimentation (100) comprenant :
- un premier substrat (101) avec un premier point de connexion de grille (111),
- un second substrat (102) avec un second point de connexion de grille (112), le premier point de connexion de grille (111) et le second point de connexion (112) étant connectés électriquement en parallèle à une borne commune (104), la borne commune (104) étant une borne de grille commune,
- une pluralité de puces semi-conductrices de puissance (103), une première partie des puces semi-conductrices de puissance (103) étant montée sur le premier substrat (101) et connectée électriquement au premier point de connexion de grille (111), et une seconde partie des puces semi-conductrices de puissance (103) étant montée sur le second substrat (102) et connectée électriquement au second point de connexion de grille (112),
- un dispositif d'amortissement d'oscillation (200), le dispositif d'amortissement d'oscillation (200) étant connecté électriquement entre le premier substrat (101) et le second substrat (102), la connexion du premier point de connexion de grille (111) et du second point de connexion de grille (112) à la borne commune (104) comprenant une disposition asymétrique,
- la connexion du premier point de connexion de grille (111) à la borne commune (104) étant située à une distance (106) de la connexion du second point de connexion de grille (112) à la borne commune (104), de telle sorte que le trajet électrique des connexions des premier et second substrats (101, 102) avec la borne commune (104) est asymétrique,
- le premier point de connexion de grille (111) étant espacé plus loin d'une ligne de borne de grille (107) que le second point de connexion de grille (112) par la distance (106).

2. Module d'alimentation (100) selon la revendication 1, le dispositif d'amortissement d'oscillation (200) comprenant un amortisseur (201), l'amortisseur (201) comprenant une résistance (202), et l'amortisseur (201) étant connecté électriquement au premier substrat (101) et au second substrat (102) dans une région (105) à l'extérieur des premier et second points de connexion de grille (111, 112).

3. Module d'alimentation (100) selon la revendication 2, l'amortisseur (201) comprenant un condensateur (203) connecté électriquement à la résistance (202).

4. Module d'alimentation (100) selon la revendication 2 ou 3, comprenant au moins l'une d'une connexion par fil (204), d'une connexion frittée (205) et d'une connexion soudée (206) pour connecter électriquement l'amortisseur (201) au premier substrat (101) ou au second substrat (102).

5. Module d'alimentation (100) selon l'une quelconque des revendications 2 et 3, l'amortisseur (201) comprenant une pluralité de résistances (202), les résistances (202) étant connectées en parallèle.

6. Module d'alimentation (100) selon l'une quelconque des revendications précédentes,
- les puces semi-conductrices de puissance (103) étant un élément parmi : un IGBT, un MOSFET, une diode, un thyristor, un JFET, un HEMT.

7. Module d'alimentation (100) selon l'une quelconque des revendications précédentes, le premier substrat (101) et le second substrat (102) étant à un potentiel électrique commun.

8. Module d'alimentation (100) selon l'une quelconque des revendications précédentes, le second point de connexion (112) étant situé entre le premier point de connexion (111) et la ligne de borne de grille (107).

9. Procédé d'assemblage d'un module d'alimentation (100), comprenant :
- la fourniture d'un premier substrat (101) avec un premier point de connexion de grille (111) et d'un second substrat (102) avec un second point de connexion de grille (112),
- la connexion du premier point de connexion de grille (111) et du second point de connexion de grille (112) en parallèle à une borne commune (104), la borne commune (104) étant une borne de grille commune, de telle sorte que la connexion du premier point de connexion de grille (111) et du second point de connexion de grille (112) à la borne commune (104) comprend une disposition asymétrique, de telle sorte que la connexion du premier point de connexion de grille (111) à la borne commune (104) est située à une distance (106) de la connexion du second point de connexion de grille (112) à la borne commune (104), de telle sorte que le trajet électrique des connexions des premier et second substrats (101, 102) avec la borne commune (104) est asymétrique, le premier point de connexion de grille (111) étant espacé plus loin d'une ligne de borne de grille (107) que le second point de connexion de grille (112) par la distance (106),
- le montage d'une première partie d'une pluralité de puces semi-conductrices de puissance (103) sur le premier substrat (101) et la connexion électrique de la première partie au premier point de connexion de grille (111),
- le montage d'une seconde partie d'une pluralité de puces semi-conductrices de puissance (103) sur le second substrat (102) et la connexion électrique de la seconde partie au second point de connexion de grille (112),
- la connexion d'un dispositif d'amortissement d'oscillation (200) électriquement entre le premier substrat (101) et le second substrat (102).
